## Europäisches Patentamt
## European Patent Office
## Office européen des brevets

(11) Veröffentlichungsnummer: **0 251 059 B1**

(12)

# EUROPÄISCHE PATENTSCHRIFT

(45) Veröffentlichungstag der Patentschrift: **29.07.92**

(51) Int. Cl.⁵: **G03F 7/095**

(21) Anmeldenummer: **87108779.7**

(22) Anmeldetag: **19.06.87**

(54) **Strahlungsempfindliches Aufzeichnungsmaterial.**

(30) Priorität: **26.06.86 DE 3621376**

(43) Veröffentlichungstag der Anmeldung:
**07.01.88 Patentblatt 88/01**

(45) Bekanntmachung des Hinweises auf die
Patenterteilung:
**29.07.92 Patentblatt 92/31**

(84) Benannte Vertragsstaaten:
**AT CH DE FR GB IT LI NL**

(56) Entgegenhaltungen:
FR-A- 2 389 155
US-A- 4 571 374

**IBM TECHNICAL DISCLOSURE BULLETIN,
Band 26, August 1983, Seite 1731, New York,
US; C.T. HORNG: "New resist combination
for forming a two-layer photoresist lift-off"**

**IBM TECHNICAL DISCLOSURE BULLETIN,
Band 23, Nr. 3, August 1983, Seite 1060, New
York, US; B.A. JETER et al.: "Lift-off structure
process"**

**MICROELECTRONIC ENGINEERING, Band 3,
Nrs 1/4, Dezember 1985, Seiten 525-531, Amsterdam, NL; "Characterisation of a two layer**
resist"

(73) Patentinhaber: **HOECHST AKTIENGESELL-
SCHAFT
Postfach 80 03 20
W-6230 Frankfurt am Main 80(DE)**

(72) Erfinder: **Elsässer, Andreas, Dr.
Hertastrasse 1B
W-6270 Idstein(DE)**
Erfinder: **Rode, Klaus, Dr.
Andreasstrasse 3
W-6200 Wiesbaden 1(DE)**

**Beschreibung**

Die Erfindung betrifft ein positiv arbeitendes strahlungsempfindliches Aufzeichnungsmaterial mit einem Schichtträger und einer strahlungsempfindlichen Schicht, die als wesentliche Bestandteile

a) eine unter Einwirkung von aktinischer Strahlung eine starke Säure bildende Verbindung,
b) eine Verbindung mit mindestens einer durch Säure spaltbaren C-O-C-Bindung und
c) ein polymeres Bindemittel

enthält. Das Material ist insbesondere zur Herstellung von Druckplatten und Photoresists geeignet.

Derartige Materialien sind bekannt und z. B. in den US-A 3 915 706, 3 917 483, 3 779 778 und 3 984 253, in den DE-A 26 10 842, 27 18 254 und 30 23 201 und den EP-A 6626, 6627 und 22 571 beschrieben. Sie sind wesentlich lichtempfindlicher als die sonst üblichen positiv arbeitenden strahlungsempfindlichen Aufzeichnungsmaterialien auf Basis von 1,2-Chinondiaziden.

Ein Nachteil dieser Aufzeichnungsmaterialien ist es, daß sie in Verbindung mit den für photolithographische und reprographische Anwendungen üblichen Trägermaterialien, z. B. Aluminium, Kupfer, Stahl, Zink, Messing, Chrom und Kunststoffolien, keine befriedigende Lagerfähigkeit aufweisen. Dies ist insbesondere dann der Fall, wenn die Trägermaterialien zur Verbesserung der Haftung der strahlungsempfindlichen Schicht in allgemein üblicher und bevorzugter Weise mit sauren oder alkalischen Mitteln vorbehandelt worden sind. Das gleiche gilt, wenn die Trägermaterialien durch Einwirkung von Luft und/oder Feuchtigkeit an ihrer Oberfläche Reaktionsprodukte mit saurem oder basischem Charakter gebildet haben.

Aufgabe der Erfindung war es, positiv arbeitende strahlungs- bzw. lichtempfindliche Aufzeichnungsmaterialien auf Basis säurespaltbarer Verbindungen bereitzustellen, die eine bessere Lagerfähigkeit als die bisher bekannten Materialien dieser Art aufweisen.

Erfindungsgemäß wird ein strahlungsempfindliches Aufzeichnungsmaterial mit einem Schichtträger und einer strahlungsempfindlichen Schicht vorgeschlagen, die als wesentliche Bestandteile

a) eine unter Einwirkung von aktinischer Strahlung eine starke Säure bildende Verbindung,
b) eine Verbindung mit mindestens einer durch Säure spaltbaren C-O-C-Bindung und
c) ein polymeres Bindemittel

enthält.

Das erfindungsgemäße Aufzeichnungsmaterial ist dadurch gekennzeichnet, daß sich auf dem Schichtträger unterhalb der strahlungsempfindlichen Schicht eine weitere strahlungsempfindliche Schicht befindet, die als strahlungsempfindliche Verbindung ein 1,2-Chinondiazid enthält.

Als strahlungsempfindlich sollen im Rahmen dieser Erfindung alle Systeme bezeichnet werden, die gegen elektromagnetische Strahlung im allgemeinen Sinn, d. h. gegen infrarotes, sichtbares, ultraviolettes Licht, energiereiche Strahlung, wie Röntgen-, Elektronen- und andere Korpuskularstrahlung empfindlich sind. Vorzugsweise liegt die Empfindlichkeit im kurzwelligen sichtbaren oder nahen bis mittleren Ultraviolettbereich. Die durch Bestrahlung Säure bildende Verbindung (a) kann jedoch auch gegenüber Licht, z. B. Tageslicht, beständig und gegenüber Elektronen- oder Röntgenstrahlung empfindlich sein. Auch Laserstrahlung kann ggf. zur Bebilderung eingesetzt werden.

Die Schichtdicke der Chinondiazid enthaltenden Zwischenschicht sollte im allgemeinen kleiner sein als die der äußeren Schicht auf Basis säurespaltbarer Verbindungen. Wenn die Chinondiazidschicht dicker wird, geht zumeist der Vorteil der höheren Lichtempfindlichkeit gegenüber Materialien, die ausschließlich Schichten auf Basis von Chinondiaziden enthalten, wieder verloren. Die untere Grenze der Dicke der Chinondiazidschicht wird hauptsächlich durch die Möglichkeiten der Beschichtungstechnik bestimmt. Die Schicht kann im Prinzip beliebig dünn sein, solange sie noch zusammenhängend und ohne wesentliche Fehlstellen ist. In den meisten Fällen ergeben Schichtdicken zwischen 10 und 5000, vorzugsweise zwischen 20 und 5000 nm gute Ergebnisse. Für Druckplatten und hochauflösende, relativ dünne Photoresistschichten werden Schichtdicken von etwa 40 bis 500 nm bevorzugt. Bei dicken Photoresistschichten mit Dicken von etwa 0,01 bis 0,05 mm kann die Zwischenschicht auch wesentlich dicker als 500 nm sein, ohne daß die Lichtempfindlichkeit insgesamt wesentlich beeinträchtigt wird. Der optimale Wert für die Dicke der Zwischenschicht hängt von vielerlei Faktoren ab, z. B. von der Art und Behandlung des Trägermaterials, der Zusammensetzung der Zwischenschicht oder der Struktur der verwendeten o-Chinondiazidverbindung.

In den Fällen, wo eine hohe Lichtempfindlichkeit weniger von Interesse ist, dafür aber die Verbesserung anderer Eigenschaften - z. B. die Resistenz gegen stark alkalische Entwickler - angestrebt wird, sind auch relativ höhere Werte für die Dicke der Zwischenschicht sinnvoll.

Als o-Chinondiazidverbindung sind in der Zwischenschicht grundsätzlich alle Verbindungen dieses Strukturtyps einsetzbar, wobei jedoch die stabilisierende Wirkung auf die Verbindungen mit säurespaltbaren C-O-C-Bindungen enthaltende Schicht von der Natur der Substituenten abhängen kann. Bevorzugt werden Naphthochinon(1,2)-diazid-(2)-4- oder -5-sulfonsäureester oder -amide verwendet. Von diesen werden die Ester, insbesondere die der 5-Sulfonsäuren, besonders bevorzugt. Geeignete Verbindungen dieser Art sind bekannt und z. B. in der DE-C-938 233, den DE-A 21 31 377, 25 47 905 und 28 28 017 beschrieben.

Zur Verbesserung der filmbildenden Eigenschaften werden der Zwischenschicht bevorzugt polymere, wasserunlösliche Bindemittel zugesetzt, die in organischen Lösungsmitteln löslich und in wäßrig-alkalischen Lösungen ebenfalls löslich oder zumindest quellbar sind. Beispielsweise seien genannt: Phenol- oder Kresol-Formaldehydharze, besonders Novolake, welche auch in bekannter Weise durch Umsetzung mit Epoxiden, Isocyanaten, etc. modifiziert sein können. Des weiteren eignen sich Polymere aus Vinylphenol oder Isopropenylphenol, Copolymere dieser Verbindungen mit Alkylacrylaten, Alkylmethacrylaten, Styrol etc., wie sie in der DE-A 34 06 927 beschrieben sind. Die Menge des Bindemittels ist in weiten Grenzen variierbar; bevorzugt werden jedoch Anteile des Bindemittels von 30-90 Gew.-%, besonders bevorzugt 55-85 Gew.-%.

Die Menge an o-Chinondiazidverbindungen beträgt im allgemeinen 3 bis 50, bevorzugt 7 bis 35 Gew.-%, bezogen auf die nichtflüchtigen Anteile der Schicht.

Zur Anpassung an spezielle Erfordernisse können den Schichten noch Additive wie Weichmacher, z. B. Polyvinylether - wie in der DE-A 16 22 301 beschrieben - oder hydriertes Kolophoniumharz - wie in der DE-A 30 23 201 beschrieben - zugesetzt werden; ferner Haftvermittler, Pigmente, Farbstoffe, Farbbildner und ggf. UV-Absorber. Als Farbstoffe sind besonders bevorzugt die Carbinole der Triphenylmethanfarbstoffe einsetzbar.

Zur Beschichtung des Trägermaterials werden die Schichtbestandteile im allgemeinen in einem Lösungsmittel gelöst. Die Wahl des Lösungsmittels richtet sich nach dem Beschichtungsverfahren, der Schichtdicke und den Trocknungsbedingungen. Geeignet sind prinzipiell alle Lösungsmittel, die mit den Schichtbestandteilen verträglich sind, wie z. B. Alkohole, Ketone, Ester, chlorierte Kohlenwasserstoffe etc.. Bevorzugt werden Gemische mit Glykolethern.

Zum Trocknen der Zwischenschicht können die üblichen Geräte und Bedingungen übernommen werden; Trocknungstemperaturen von 100° C sind im allgemeinen ausreichend.

Auf die als Stabilisierungsschicht dienende Zwischenschicht wird die eigentliche hochlichtempfindliche Schicht auf Basis säurespaltbarer Verbindungen aufgebracht.

Als durch Säure spaltbare Verbindungen sind in erster Linie zu nennen:

A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

B) Oligomer- oder Polymerverbindungen mit wiederkehrenden Acetal- und/oder Ketalgruppierungen in der Hauptkette und

C) Verbindungen mit mindestens einer Enolether- oder N-Acyliminocarbonatgruppierung.

Durch Säure spaltbare Verbindungen des Typs A) als Komponenten strahlungsempfindlicher Gemische sind in der EP-A 0 022 571 ausführlich beschrieben; Gemische, die Verbindungen des Typs B) enthalten, sind in der DE-C 23 06 248 und der DE-C 27 18 254 beschrieben; Verbindungen des Typs C) werden in den EP-A 0 006 626 und 0 006 627 beschrieben.

Der Anteil der spaltbaren Verbindung kann variiert werden zwischen 5 und 70 Gew.-%, bevorzugt werden 5 bis 40 Gew.-%.

Die äußere strahlungsempfindliche Schicht enthält ferner ein polymeres, bevorzugt wasserunlösliches Bindemittel, das in organischen Lösungsmitteln löslich ist. Da sich als Entwicklerflüssigkeiten für die belichteten Schichten mit Vorteil wäßrig-alkalische Lösungen einsetzen lassen und diese im allgemeinen gegenüber Entwicklern auf Basis organischer Lösungsmittel vorgezogen werden, werden insbesondere solche Bindemittel bevorzugt, die in wäßrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 90, besonders bevorzugt 55 - 85 Gew.-%.

Die bei vielen Positiv-Kopiermaterialien bewährten Phenolharze, vor allem Novolake, haben sich auch bei den erfindungsgemäßen Materialien als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure sowie die als Bestandteile der Chinondiazidschicht beschriebenen Polymeren sind ebenfalls als Bindemittel geeignet.

Zusätzlich können noch zahlreiche andere Harze mitverwendet werden, die entweder wasserlöslich oder aber alkaliunlöslich sein können, bevorzugt Vinylpolymerisate wie Polyvinylacetate; Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Die Wirkung dieser halogenhaltigen Verbindungen kann auch durch bekannte Sensibilisatoren spektral beeinflußt und gesteigert werden.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxystyryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxy-anthrac-1-yl)-, 2-(4-Styryl-phenyl)-, 2-(Phenanthr-9-yl)-4,6-bis-trichlrmethyl-s-triazin und die in den Beispielen angeführten Verbindungen.

Die Menge des Starters kann je nach seiner chemischen Natur und der Zusammensetzung der Schicht ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 0,01 mm empfiehlt es sich, relativ wenig Säurespender zu verwenden.

Schließlich können der lichtempfindlichen Schicht noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Schichtdicke der äußeren strahlungs- bzw. lichtempfindlichen Schicht richtet sich im wesentlichen nach dem vorgesehenen Anwendungszweck des Materials. Sie kann im allgemeinen zwischen etwa 500 nm und 0,08 mm, vorzugsweise 0,001 bis 0,05 mm liegen. Für Druckplatten und aus Lösungen aufzubringende Photoresistschichten werden Schichtdicken im Bereich von 0,001 bis 0,01 mm bevorzugt.

Zum Aufbringen der oberen lichtempfindlichen Schicht können grundsätzlich die gleichen Lösungsmittel wie für die Chinondiazidschicht verwendet werden. Überraschenderweise tritt dabei keine Verschlechterung der Stabilisierungswirkung der Zwischenschicht ein, obwohl damit zu rechnen ist, daß diese teilweise von dem Lösungsmittel der zweiten Beschichtungslösung angelöst wird und ihre Bestandteile mit den unteren Bereichen der oberen lichtempfindlichen Schicht vermischt werden. Offenbar bleibt in jedem Fall eine zusammenhängende sehr dünne Chinondiazidschicht unmittelbar auf dem Schichtträger erhalten, deren Dicke zur Erzielung der erfindungsgemäß erwünschten Stabilisierung ausreicht.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 0,01 mm sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 0,01 mm werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben.

Für die Trocknung nach der Beschichtung können die üblichen Geräte und Bedingungen übernommen werden, Temperaturen um 100° C und kurzfristig bis 120° C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Mit Vorteil werden Laserbestrahlungsgeräte, insbesondere automatische Verarbeitungsanlagen verwendet, die als strahlungsquelle einen Argon-Ionen-Laser enthalten.

Die Bestrahlung kann auch mit Elektronenstrahlen erfolgen. In diesem Falle können auch im üblichen Sinne nicht lichtempfindliche-Säure bildende Verbindungen als Initiatoren der Solubilisierungsreaktion eingesetzt werden, z. B. halogenierte aromatische Verbindungen oder halogenierte polymere Kohlenwasserstoffe. Röntgen- oder Ionenstrahlen können ebenfalls zur Bilderzeugung verwendet werden.

Die bildmäßig belichtete oder bestrahlte Schicht kann in bekannter Weise mit den für handelsübliche Naphthochinondiazid-Schichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate, -borate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Im folgenden werden Beispiele für bevorzugte Ausführungsformen des erfindungsgemäßen Aufzeichnungsmaterials angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Beispiel 1

Dieses Beispiel zeigt den Einfluß der Dicke der Zwischenschicht auf die Lichtempfindlichkeit und die Lagerstabilität der erfindungsgemäßen Aufzeichnungsmaterialien.

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

| | |
|---|---|
| 6,6 Gt | Kresol-Formaldehyd-Novolak (Schmelzpunkt nach Kapillarmethode DIN 53 181: 105-120° C) und |
| 1,6 Gt | Trisester aus Naphthochinon-(1,2)-diazid-(2)-5-sulfonylchlorid und 2,3,4-Trihydroxybenzophenon in |
| 82,0 Gt | Tetrahydrofuran, |
| 65,6 Gt | 2-Methoxyethanol und |
| 16,4 Gt | Butylacetat |

Durch Variation der Schleudergeschwindigkeit werden verschiedene Schichtdicken erhalten (s. Tabelle 1). Die Schichten werden 2 Minuten bei 100° C in einem Umlufttrockenschrank getrocknet. Anschließend wird eine Schicht aufgeschleudert, die enthält:

| 4,7 Gt | Novolak (s.o.), |
|---|---|
| 1,4 Gt | Polyacetal aus 2-Ethylbutyraldehyd und Triethylenglykol, |
| 0,23 Gt | 2-(4-Styrylphenyl)-4,6-bis-trichlormethyl-s-triazin und |
| 0,02 Gt | Kristallviolett-Base in |
| 93,65 Gt | Butanon. |

Es wird eine Schichtdicke von 1500 nm erhalten. Nach Trocknung wie oben werden die Platten unter einer 5-kW-Metallhalogenid-Lampe im Abstand von 110 cm durch einen Halbtonstufenkeil mit 13 Dichtestufen von je 0,15 (Belichtungskeil "BK01" der Firma HOECHST AG, Werk Kalle) 10 Sekunden belichtet und nach 10 Minuten Warten in einem Entwickler folgender Zusammensetzung 30 Sekunden entwickelt:

| 8,5 Gt | $Na_2SiO_3 \times 9\,H_2O$, |
|---|---|
| 0,8 Gt | NaOH und |
| 1,5 Gt | $Na_2B_4O_7 \times 10\,H_2O$ in |
| 89,2 Gt | $H_2O$ |

Danach wird mit fetter schwarzer Druckfarbe eingefärbt und die erste Stufe des Halbtonkeils ermittelt, die die Farbe voll annimmt. Ein Teil der Platten wurde nach der Herstellung 4 Stunden in einer wasserdampfgesättigten Atmosphäre bei 80° C gelagert und dann ebenso verarbeitet. Die folgende Tabelle zeigt die Resultate.

Tabelle 1

| Dicke der Zwischenschicht (nm) | erste gedeckte Stufe im Halbtonkeil | Veränderung des Halbtonkeils nach 4-stündiger forcierter Lagerung in ganzen Stufen |
|---|---|---|
| 0 | 9 | 2 |
| 100 | 8 | 0 |
| 200 | 8 | 0 |
| 400 | 8 | 0 |
| 600 | 8 | 0 |
| 1000 | 7 | 0 |
| 1500 | 7 | 0 |

Beispiel 2

Dieses Beispiel zeigt die Eignung des erfindungsgemäßen Aufzeichnungsmaterials mit verschiedenen Trägermaterialien.

Auf verschiedene Trägermaterialien werden zwei Schichten wie in Beispiel 1 aufgeschleudert, wobei für die Dicke der Zwischenschicht ein einheitlicher Wert von 200 nm eingestellt wurde. Es wird wie in Beispiel 1 belichtet und entwickelt.

Träger 1: in Salpetersäure elektrolytisch aufgerauhte, in Schwefelsäure anodisierte und mit Polyvinylphosphonsäure hydrophilierte Aluminiumplatte,

Träger 2: wie Träger 1, aber ohne Polyvinylphosphonsäurebehandlung,

Träger 3: wie Träger 1, aber mit $Na_2SiO_3$-Lösung hydrophiliert,

Träger 4: mit einer Schleifmittelsuspension mechanisch aufgerauhte und mit Polyvinylphosphonsäure hydrophilierte Aluminiumplatte,

Träger 5: mit Bürsten mechanisch aufgerauhte Kupfer-Platte,

Träger 6: mechanisch aufgerauhte Zinkplatte,

Träger 7: mit einem $SiO_2$-Film bedeckter Silicium-Wafer,

Träger 8: mit Polyvinylalkohol und Kieselsäuresol behandelte Polyester-Folie.

Tabelle 2

| Träger | Zwischenschicht | erste gedeckte Stufe im Halbtonkeil | Veränderung des Halbtonkeils nach 4-stündiger forcierter Lagerung |
|---|---|---|---|
| 1 | nein | 9 | 2 |
| 1 | ja | 8 | 0 |
| 2 | nein | 9 | 2 |
| 2 | ja | 8 | 0 |
| 3 | nein | 9 | 2 |
| 3 | ja | 8 | 0 |
| 4 | nein | 9 | 2 |
| 4 | ja | 8 | 0 |
| 5 | nein | 9 | 2 |
| 5 | ja | 8 | 0 |
| 6 | nein | 9 | 2 |
| 6 | ja | 8 | 0 |
| 7 | nein | 9 | 2 |
| 7 | ja | 8 | 0 |
| 8 | nein | 4 | 1 |
| 8 | ja | 3 | 0 |

Beispiel 3

Dieses Beispiel zeigt die Eignung des erfindungsgemäßen Aufzeichnungsmaterials zur Herstellung von Flachdruckplatten.

Eine in Salpetersäure elektrolytisch aufgerauhte, in Schwefelsäure anodisierte und mit Polyvinylphosphonsäure hydrophilierte Aluminiumplatte wird mit folgender Lösung schleuderbeschichtet:

| | |
|---|---|
| 6,6 Gt | Novolak wie in Beispiel 1, |
| 1,6 Gt | Naphthochinondiazid wie in Beispiel 1 und |
| 0,02 Gt | Kristallviolett-Base in |
| 82,0 Gt | Tetrahydrofuran, |
| 65,6 Gt | 2-Methoxy-ethanol und |
| 16,4 Gt | Butylacetat. |

Die Schicht wird 2 Minuten bei 100° C im Umlufttrockenschrank getrocknet. Es wird eine Schichtdicke von 200 nm erhalten. Anschließend wird eine Schicht aufgeschleudert, die enthält:

| | |
|---|---|
| 4,0 Gt | Novolak wie in Beispiel 1, |
| 1,2 Gt | Polymerer Orthoester aus 4-Oxa-6,6-bis-hydroxymethyl-octan-1-ol und Orthoameisensäuretriethylester, |
| 0,20 Gt | 2-(4-Styrylphenyl)-4,6-bis-trichlormethyl-s-triazin und |
| 0,02 Gt | Kristallviolett-Base in |
| 94,60 Gt | Butanon |

Es wird eine Schichtdicke von 2000 nm erhalten. Die Platte wird 10 Sekunden bildmäßig mit einer 5 kW-Metallhalogenid-Lampe im Abstand von 110 cm belichtet, eine Minute auf 80° C erwärmt und dann im Entwickler aus Beispiel 1 eine Minute entwickelt. Mit der so hergestellten Offsetdruckform werden 100.000 Drucke von einwandfreier Qualität erhalten.

Beispiel 4

Dieses Beispiel zeigt die Eignung des erfindungsgemäßen Aufzeichnungsmaterials für die Bebilderung mit Elektronenstrahlen.

Auf mechanisch aufgerauhtes Aluminium wird eine 100 nm dicke Zwischenschicht der in Beispiel 1 angegebenen Zusammensetzung aufgebracht. Darauf wird eine Lösung folgender Zusammensetzung schleuderbeschichtet:

| | |
|---|---|
| 4,0 Gt | Novolak wie in Beispiel 1, |
| 1,2 Gt | Bis-(5-butyl-5-ethyl-1,3-dioxan-2-yl)-ether des 2-Butyl-2-ethyl-propandiols, |
| 0,20 Gt | 2-(4-Ethoxy-naphth-1-yl)-4,6-bis-trichlormethyl-s-triazin und |
| 0,02 Gt | Kristallviolett-Base in |
| 94,60 Gt | Butanon |

Es wird eine Schichtdicke von 1000 nm erhalten. Die Bestrahlung erfolgt mit 11 kV-Elektronen. Bei einem Strahlstrom von $5 \cdot 10^{-6}$ A reichen 4 Sekunden Bestrahlungsdauer aus, um ein Feld von 10 Quadratzentimetern nach 90 Sekunden Einwirkung des Entwicklers aus Beispiel 1 löslich zu machen. Dies entspricht einer Empfindlichkeit der oben genannten Schichten von $2 \cdot 10^{-6}$ C/cm$^2$.

Beispiel 5

Dieses Beispiel zeigt die Eignung des erfindungsgemäßen Materials als Ätzreserve.

Eine Kupferplatte wird mit einer 200 nm dicken Zwischenschicht wie in Beispiel 1 versehen. Darauf wird folgende Lösung durch Schleudern aufgebracht:

| | |
|---|---|
| 40 Gt | Novolak wie in Beispiel 1, |
| 11,7 Gt | Polyacetal aus Triethylenglykol und Butyraldehyd, |
| 0,50 Gt | 2-(4-Ethoxy-naphth-1-yl)-4,6-bis-trichlormethyl-s-triazin und |
| 0,10 Gt | Kristallviolett-Base in |
| 50,0 Gt | Ethanol und |
| 60,0 Gt | Butanon. |

Nach 10 Minuten Trocknen bei 100° C resultiert eine Schichtdicke von 0,025 mm. Es wird mit einer 5 kW-Metallhalogenid-Lampe (110 cm Abstand) ca. 50 Sekunden belichtet und nach einer Wartezeit von 15 Minuten 90 Sekunden mit dem in Beispiel 1 angegebenen Entwickler entwickelt. Die entstandene Resistschablone weist eine hervorragende Ätz- und Galvanoresistenz auf, insbesondere beim galvanischen Aufbau von Kupfer und Pb/Sn-Legierung.

Beispiel 6

Dieses Beispiel zeigt die Eignung des erfindungsgemäßen Aufzeichnungsmaterials als hochauflösende Photoresistschablone.

Auf einen mit einem SiO$_2$-Film bedeckten Silicium-Wafer wird eine Zwischenschicht wie in Beispiel 1 in einer Dicke von 200 nm aufgeschleudert, wobei die Lösung vorher durch ein Filter mit einem Porendurchmesser von 200 nm (Millipore) filtriert wurde. Darauf wird folgende, ebenso filtrierte Lösung schleuderbeschichtet:

| | |
|---|---|
| 12,5 Gt | Novolak wie in Beispiel 1, |
| 2,1 Gt | Polyacetal wie in Beispiel 1 und |
| 0,1 Gt | 2-(4-Styrylphenyl)-4,6-bis-trichlormethyl-s-triazin in |
| 85,0 Gt | 2-Ethoxy-ethylacetat. |

Nach 1 Minute Trocknen bei 100° C wird eine Dicke von 1000 nm erhalten. Eine Testbildmaske wird in innigen Kontakt mit dem Wafer gebracht, der 15 Sekunden mit UV-Licht einer Intensität von 4,5 mW/cm$^2$ bei 365 nm belichtet wild. Nach 10 Minuten Warten wird 45 Sekunden mit dem Entwickler aus Beispiel 1 entwickelt. Das erhaltene Bildmuster zeigt eine Auflösung von 1000 nm.

**Patentansprüche**

1. Strahlungsempfindliches Aufzeichnungsmaterial mit einem Schichtträger und einer strahlungsempfindlichen Schicht, die als wesentliche Bestandteile

a) eine unter Einwirkung von aktinischer Strahlung eine starke Säure bildende Verbindung,

b) eine Verbindung mit mindestens einer durch Säure spaltbaren C-O-C-Bindung und

c) ein polymeres Bindemittel

enthält, dadurch gekennzeichnet, daß sich auf dem Schichtträger unterhalb der strahlungsempfindlichen Schicht eine weitere strahlungsempfindliche Schicht befindet, die als strahlungsempfindliche Verbindung ein 1,2-Chinondiazid enthält.

2. Aufzeichnungsmaterial nach Anspruch 1, dadurch gekennzeichnet, daß die Chinondiazidschicht dünner ist als die darüberliegende strahlungsempfindliche Schicht.

3. Aufzeichnungsmaterial nach Anspruch 2, dadurch gekennzeichnet, daß die Chinondiazidschicht 10 bis 5000 nm dick ist.

4. Aufzeichnungsmaterial nach Anspruch 1, dadurch gekennzeichnet, daß die Chinondiazidschicht ein wasserunlösliches, in wäßrig-alkalischen Lösungen lösliches Bindemittel enthält.

5. Aufzeichnungsmaterial nach Anspruch 1, dadurch gekennzeichnet, daß das 1,2-Chinondiazid ein 1,2-Naphthochinon-2-diazid-sulfonsäureester ist.

6. Aufzeichnungsmaterial nach Anspruch 4, dadurch gekennzeichnet, daß die Chinondiazidschicht 30 bis 90 Gew.-% Bindemittel und 3 bis 50 Gew.-% 1,2-Chinondiazid enthält.

7. Aufzeichnungsmaterial nach Anspruch 1, dadurch gekennzeichnet, daß das polymere Bindemittel (c) wasserunlöslich und in wäßrig-alkalischen Lösungen löslich ist.

8. Aufzeichnungsmaterial nach Anspruch 1, dadurch gekennzeichnet, daß die Verbindung (b) mindestens eine Orthocarbonsäureester-, Carbonsäureamidacetal-, Acetal-, Ketal-, Enolether- oder Acyliminocarbonatgruppierung enthält.

9. Aufzeichnungsmaterial nach Anspruch 1, dadurch gekennzeichnet, daß die obere strahlungsempfindliche Schicht eine Dicke im Bereich von 500 nm bis 0,08 mm hat.

10. Aufzeichnungsmaterial nach Anspruch 1, dadurch gekennzeichnet, daß die obere strahlungsempfindliche Schicht 30 bis 90 Gew.-% polymeres Bindemittel (c), 5 bis 70 Gew.-% säurespaltbare Verbindung (b) und 0,1 bis 10 Gew.-% durch Bestrahlung Säure bildende Verbindung (a) enthält.

**Claims**

1. A radiation-sensitive recording material comprising a support and a radiation-sensitive layer which contains as the essential constituents

a) a compound which forms a strong acid under the action of actinic radiation,

b) a compound which has at least one acid-cleavable C-O-C bond and

c) a polymeric binder,

wherein, underneath the radiation-sensitive layer, an additional radiation-sensitive layer containing a 1,2-quinone diazide as the radiation-sensitive compound, is present on the support.

2. A recording material as claimed in claim 1, wherein the quinone diazide layer is thinner than the superposed radiation-sensitive layer.

3. A recording material as claimed in claim 2, wherein the qininone diazide layer has a thickness of from 10 to 5,000 nm.

4. A recording material as claimed in claim 1, wherein the quinone diazide layer contains a binder that is insoluble in water and soluble in aqueous-alkaline solutions.

5. A recording material as claimed in claim 1, wherein the 1,2-quinone diazide comprises a 1,2-naphthoquinone-2-diazide-sulfonic acid ester.

6.  A recording material as claimed in claim 4, wherein the quinone diazide layer contains from 30 to 90 percent by weight of the binder and from 3 to 50 percent by weight of 1,2-quinone diazide.

7.  A recording material as claimed in claim 1, wherein the polymeric binder (c) is insoluble in water and soluble in aqueous-alkaline solutions.

8.  A recording material as claimed in claim 1, wherein compound (b) comprises at least one orthocarboxylic acid ester, carboxylic acid amide acetal, acetal, ketal, enolic ether or acyl-iminocarbonate grouping.

9.  A recording material as claimed in claim 1, wherein the outer radiation-sensitive layer has a thickness in the range from 500 nm to 0.08 mm.

10. A recording material as claimed in claim 1, wherein the outer radiation-sensitive layer comprises from 30 to 90 percent by weight of polymeric binder (c), from 5 to 70 percent by weight of acid-cleavable compound (b) and from 0.1 to 10 percent by weight of compound (a) which forms an acid under the action of radiation.

## Revendications

1.  Matériau de reprographie sensible aux radiations, comportant un support de couche et une couche sensible aux radiations, qui contient, en tant que composants essentiels,
    a) un composé formant un acide fort sous l'effet d'un rayonnement actinique,
    b) un composé comportant au moins une liaison C-O-C pouvant être rompue par un acide, et
    c) un liant polymère,
    caractérisé en ce que sur le support de couche, au-dessous de la couche sensible aux radiations, se trouve une autre couche sensible aux radiations, qui contient un 1,2-quinonediazide en tant que composé sensible aux radiations.

2.  Matériau de reprographie selon la revendication 1, caractérisé en ce que la couche à base de quinonediazide est plus mince que la couche sus-jacente, sensible aux radiations.

3.  Matériau de reprographie selon la revendication 2, caractérisé en ce que la couche à base de quinonediazide a une épaisseur de 10 à 5 000 nm.

4.  Matériau de reprographie selon la revendication 1, caractérisé en ce que la couche à base de quinonediazide contient un liant insoluble dans l'eau, soluble dans des solutions aqueuses-alcalines.

5.  Matériau de reprographie selon la revendication 1, caractérisé en ce que le 1,2-quinonediazide est un ester d'acide 1,2-naphtoquinone-2-diazide-sulfonique.

6.  Matériau de reprographie selon la revendication 4, caractérisé en ce que la couche à base de quinonediazide contient de 30 à 90 % en poids de liant et de 3 à 50 % en poids de 1,2-quinonediazide.

7.  Matériau de reprographie selon la revendication 1, caractérisé en ce que le liant polymère (c) est insoluble dans l'eau et soluble dans des solutions aqueuses-alcalines.

8.  Matériau de reprographie selon la revendication 1, caractérisé en ce que le composé (b) contient au moins un groupement ester d'acide orthocarboxylique, acétal de carboxamide, acétal, cétal, énol-éther ou acyliminocarbonate.

9.  Matériau de reprographie selon la revendication 1, caractérisé en ce que la couche supérieure sensible aux radiations a une épaisseur dans la plage allant de 500 nm à 0,08 mm.

10. Matériau de reprographie selon la revendication 1, caractérisé en ce que la couche supérieure sensible aux radiations contient de 30 à 90 % en poids de liant polymère (c), de 5 à 70 % en poids de composé (b) dissociable par un acide, et de 0,1 à 10 % en poids de composé (a) formant un acide sous l'effet d'irradiation.